# EUROPEAN PATENT APPLICATION

(11) **EP 4 840 984 A1**
(43) Date of publication of application: **18.11.2026**
(21) Application number: 25738771.2
(22) Date of filing: 08.01.2025
(51) Int. Cl.: C23C 14/04

(54) **MASK DEVICE AND METHOD FOR MANUFACTURING ORGANIC DEVICE**

(30) Priority: 10.01.2024 JP 2024002120
(71) Applicant: Dai Nippon Printing Co., Ltd., Tokyo 162-8001 (JP)
(72) Inventor: AMIE, Takashi, Tokyo 162-8001 (JP); OBATA, Katsunari, Tokyo 162-8001 (JP); HOKARI, Kumiko, Tokyo 162-8001 (JP); KIURA, Shinya, Tokyo 162-8001 (JP)
(74) Representative: Müller-Boré & Partner Patentanwälte PartG mbB
(86) International application number: PCT/JP2025/000300
(87) International publication number: WO 2025/150503

(57) **Abstract**

A mask assembly includes a mask and a frame connected to the mask. The mask includes a first layer and a second layer. The first layer includes a first surface, a second surface, and at least one first opening. The second layer includes a third surface facing toward the second surface, a fourth surface, and a plurality of second openings overlapping the first opening. The frame faces toward the first surface of an outer region of the first layer. At least a part of the frame extends outward beyond an outer edge of the first layer in plan view. The mask is fixed to the frame by a screw.

## Description

### Technical Field

Embodiments of the present disclosure relate to a mask assembly and a method for manufacturing an organic device.

### Background Art

A vapor deposition method is known as a method for forming a precise pattern. In the vapor deposition method, first, a mask having openings formed therein is combined with a substrate. Subsequently, a vapor deposition material is deposited on the substrate through the openings of the mask. As a result, vapor deposition layers containing the vapor deposition material are formed on the substrate in a pattern corresponding to a pattern of the openings of the mask. The vapor deposition method is used, for example, as a method for forming pixels of an organic EL display device. Patent Literature 1 discloses a mask used in the vapor deposition method.

### Citation List

### Patent Literature

PTL 1: Japanese Unexamined Patent Application Publication No. 2009-062565

### Summary of Invention

### Technical Problem

When openings are formed up to the vicinity of the outer edge of a mask, an outer edge portion of the mask is easily damaged, and handling the mask becomes difficult. In addition, when the openings are formed up to the vicinity of the outer edge, the outer edge portion of the mask is narrow. As a result, when the mask is gripped, not only the outer edge portion but also a region inside the outer edge portion, that is, a region in which the openings of the mask are formed, may be gripped. In this case, the region in which the openings of the mask are formed may be contaminated. On the other hand, it is required to enable vapor deposition layers to be formed over a wider range of a substrate with a single mask by forming openings up to the vicinity of the outer edge of the mask.

An object of an embodiment of the present disclosure is to effectively solve such a problem.

### Solution to Problem

A mask assembly according to an embodiment of the present disclosure includes a mask, and a frame connected to the mask, wherein the mask may include a first layer that includes a first surface, a second surface located opposite to the first surface, at least one first opening penetrating through the first layer from the first surface to the second surface, an outer edge, and an outer region located between the outer edge and the first opening in plan view, and a second layer that includes a third surface facing toward the second surface, a fourth surface located opposite to the third surface, and a plurality of second openings penetrating through the second layer from the third surface to the fourth surface and overlapping the first opening in plan view, the frame may face toward the first surface of the outer region of the first layer, at least a part of the frame may extend outward beyond the outer edge of the first layer in plan view, and the frame may be fixed to the mask by a screw.

### Advantageous Effects of Invention

According to the embodiment of the present disclosure, handling of a mask is facilitated.

### Brief Description of Drawings

[Fig. 1] Fig. 1 is a cross-sectional view illustrating an example of an organic device.
[Fig. 2] Fig. 2 is a view illustrating an example of a vapor deposition apparatus provided with a mask assembly.
[Fig. 3] Fig. 3 is a plan view illustrating an example of a mask assembly as viewed from an entrance surface side.
[Fig. 4] Fig. 4 is a plan view illustrating an example of the mask assembly as viewed from an exit surface side.
[Fig. 5A] Fig. 5A is a cross-sectional view of the mask assembly in Fig. 3 taken along line V-V.
[Fig. 5B] Fig. 5B is an enlarged view of a portion enclosed by the two-dot chain line in the cross section illustrated in Fig. 5A.
[Fig. 5C] Fig. 5C is a cross-sectional view illustrating an example of an effective region.
[Fig. 6] Fig. 6 is an enlarged view of a portion enclosed by the two-dot chain line in the cross section illustrated in Fig. 5B.
[Fig. 7] Fig. 7 is a view corresponding to Fig. 6 and illustrating a modification of the mask assembly.
[Fig. 8] Fig. 8 is a cross-sectional view illustrating an example of a method for manufacturing a mask assembly according to an embodiment.
[Fig. 9] Fig. 9 is a cross-sectional view illustrating an example of a method for manufacturing a mask assembly according to an embodiment.
[Fig. 10] Fig. 10 is a cross-sectional view illustrating an example of a method for manufacturing a mask assembly according to an embodiment.
[Fig. 11] Fig. 11 is a cross-sectional view illustrating an example of a method for manufacturing a mask assembly according to an embodiment.
[Fig. 12] Fig. 12 is a cross-sectional view illustrating an example of a method for manufacturing a mask assembly according to an embodiment.
[Fig. 13] Fig. 13 is a cross-sectional view illustrating an example of a method for manufacturing a mask assembly according to an embodiment.
[Fig. 14] Fig. 14 is a cross-sectional view illustrating an example of a method for manufacturing a mask assembly according to an embodiment.
[Fig. 15] Fig. 15 is a cross-sectional view illustrating an example of a method for manufacturing a mask assembly according to an embodiment.
[Fig. 16] Fig. 16 is a cross-sectional view illustrating an example of a method for manufacturing a mask assembly according to an embodiment.
[Fig. 17] Fig. 17 is a cross-sectional view illustrating an example of a method for manufacturing a mask assembly according to an embodiment.
[Fig. 18] Fig. 18 is a cross-sectional view illustrating an example of a method for manufacturing a mask assembly according to an embodiment.
[Fig. 19] Fig. 19 is a cross-sectional view illustrating an example of a method for manufacturing a mask assembly according to an embodiment.
[Fig. 20] Fig. 20 is a cross-sectional view illustrating an example of a method for manufacturing a mask assembly according to an embodiment.
[Fig. 21] Fig. 21 is a cross-sectional view illustrating an example of a method for manufacturing a mask assembly according to an embodiment.
[Fig. 22] Fig. 22 is a cross-sectional view corresponding to Fig. 6 and illustrating a modification of the mask assembly.
[Fig. 23] Fig. 23 is a cross-sectional view corresponding to Fig. 6 and illustrating another modification of the mask assembly.
[Fig. 24] Fig. 24 is a view illustrating an example of a device including an organic device.

### Description of Embodiments

In the present specification and the drawings, unless otherwise specified, terms such as "substrate", "sheet", and "film", which mean a substance serving as a base of a certain configuration, are not distinguished from one another based solely on the difference in name.

In the present specification and the drawings, unless otherwise specified, terms such as "parallel" and "orthogonal", values of length and angle, and the like, which specify shapes, geometric conditions, and degrees thereof, are not limited to their strict meanings and should be interpreted as including ranges that permit substantially the same functions to be achieved.

In the present specification and the drawings, unless otherwise specified, when an element such as a member or a region is "on" or "beneath", "over" or "under ", or "above" or "below" another element such as another member or another region, this includes not only cases where the two elements are in direct contact with each other, but also cases where one or more additional elements are interposed between them, that is, cases where two elements are in indirect contact with each other. In addition, unless otherwise specified, the terms "on", "over", "above", "beneath", "under ", and "below" may be interpreted with the vertical direction reversed.

In the present specification and the drawings, unless otherwise specified, a state where a surface of an element A "faces" a surface of an element B includes not only a case where the surface of the element A is in contact with the surface of the element B, but also a case where an element C is positioned between the surface of the element A and the surface of the element B. That is, the term "face" is a term representing the orientation of two surfaces.

In this specification and the drawings, the same portions or portions having the same or similar functions are denoted by the same reference signs or similar reference signs unless otherwise specified, and repeated description thereof may be omitted. In addition, for convenience of description, a dimensional ratio in the drawings may be different from the actual ratio, or a part of the configuration may be omitted from the drawings.

In the present specification and the drawings, unless otherwise specified, one embodiment of the present specification can be combined with another example as long as no contradiction occurs. In addition, other examples may also be combined with each other as long as no contradiction occurs.

In the present specification and the drawings, when two or more steps or processes relating to a method such as a manufacturing method are disclosed, unless otherwise specified, other steps or processes that are not disclosed may be performed between the disclosed steps or processes. In addition, the disclosed steps or processes may be performed in any order as long as no contradiction occurs.

In an example described according to an embodiment of the present specification, a mask is used to form organic layers or electrodes on a substrate when an organic EL display device is manufactured. However, the application of the mask is not particularly limited, and the present embodiment can be applied to masks used for various applications. For example, the mask according to the present embodiment may be used to form electrodes of a device for displaying or projecting an image or video for expressing virtual reality, so-called VR, or augmented reality, so-called AR. The mask according to the present embodiment may be used to form electrodes of a display device other than an organic EL display device, such as electrodes of a liquid crystal display device. The mask according to the present embodiment may be used to form electrodes of an organic device other than a display device, such as electrodes of a pressure sensor.

A first aspect of the present disclosure is
a mask assembly including:
a mask; and
a frame connected to the mask,
wherein the mask includes
a first layer that includes a first surface, a second surface located opposite to the first surface, at least one first opening penetrating through the first layer from the first surface to the second surface, an outer edge, and an outer region located between the outer edge and the first opening in plan view, and
a second layer that includes a third surface facing toward the second surface, a fourth surface located opposite to the third surface, and a plurality of second openings penetrating through the second layer from the third surface to the fourth surface and overlapping the first opening in plan view,
the frame faces toward the first surface of the outer region of the first layer,
at least a part of the frame extends outward beyond the outer edge of the first layer in plan view, and
the mask is fixed to the frame by a screw.

In the mask assembly according to a second aspect in accordance with the first aspect described above,
the first layer may contain silicon or a silicon compound, and
the frame may contain glass or metal.

The mask assembly according to a third aspect in accordance with the first aspect or the second aspect described above may further include a buffer material between the mask and the frame.

In the mask assembly according to a fourth aspect in accordance with any one of the first aspect to the third aspect described above,
the mask and the frame may be disposed in this order in a direction from a head toward a shaft of the screw, and
the mask assembly may further include a buffer material between a tip of the shaft of the screw and the frame.

In the mask assembly according to a fifth aspect in accordance with any one of the first aspect to the fourth aspect described above,
the mask and the frame may be disposed in this order in a direction from a head toward a shaft of the screw, and
a top surface of the head of the screw may be flush with the fourth surface of the second layer, or may be located between the fourth surface and the first surface of the first layer.

In the mask assembly according to a sixth aspect in accordance with any one of the first aspect to the fifth aspect described above, the mask may be fixed to the frame by two or more screws.

In the mask assembly according to a seventh aspect in accordance with any one of the first aspect to the sixth aspect described above, the mask may be fixed to the frame by one or more pairs of screws, the pairs each being arranged with the plurality of second openings interposed therebetween in plan view.

In the mask assembly according to an eighth aspect in accordance with any one of the first aspect to the seventh aspect described above, a stepped portion that receives at least a part of the mask may be formed in the frame.

In the mask assembly according to a ninth aspect in accordance with any one of the first aspect to the eighth aspect described above, the mask may be detachably fixed to the frame.

In the mask assembly according to a tenth aspect in accordance with any of the first aspect to the ninth aspect described above, the screw may be made of the same material as the frame.

An eleventh aspect of the present disclosure is a method for manufacturing an organic device, the method including a step of forming organic layers on a substrate by a vapor deposition method using the mask assembly according to any one of the first aspect to the tenth aspect described above.

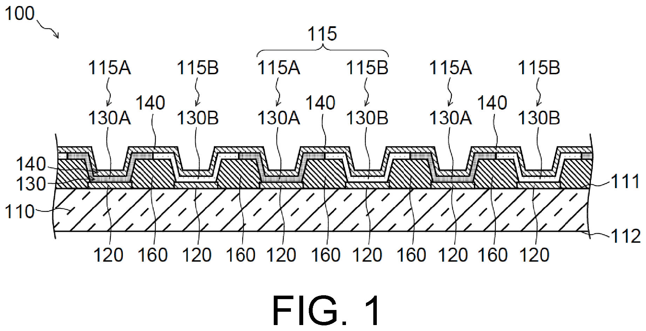

An embodiment will be described with reference to Figs. 1 to 21. First, an organic device 100 including organic layers formed by using a mask will be described. Fig. 1 is a cross-sectional view illustrating an example of the organic device 100.

The organic device 100 includes a substrate 110 and a plurality of elements 115 arranged in an in-plane direction of the substrate 110. The substrate 110 includes a first surface 111 and a second surface 112 located opposite to the first surface 111. The elements 115 are located on the first surface 111. The elements 115 are, for example, pixels. The substrate 110 may include two or more types of elements 115. For example, the substrate 110 may include first elements 115A and second elements 115B. Although not illustrated, the substrate 110 may include third elements. The first elements 115A, the second elements 115B, and the third elements are, for example, red pixels, blue pixels, and green pixels, respectively.

The elements 115 may each include first electrodes 120, organic layers 130 located on the first electrodes 120, and second electrodes 140 located on the organic layers 130.

The organic device 100 may include insulating layers 160 each of which is located between two first electrodes 120 that are disposed next to each other in plan view. The insulating layers 160 contain, for example, polyimide. The insulating layers 160 may overlap with end portions of the first electrodes 120. The expression "in plan view" means viewing an object in the normal direction of a surface of a plate-like member such as the substrate 110.

The substrate 110 may be a member having insulating properties. Examples of materials for the substrate 100 may include a non-flexible rigid material such as silicon, quartz glass, Pyrex (registered trademark) glass, or a synthetic quartz plate, or a flexible material having flexibility such as a resin film, an optical resin plate, and thin glass. The substrate 110 may have a planar shape similar to that of a silicon wafer used in semiconductor manufacturing. In this case, the substrate 110 can be processed using an apparatus for performing a semiconductor manufacturing process. For example, the first electrodes 120, the insulating layers 160, and the like can be formed on the substrate 110 using an apparatus for performing a semiconductor manufacturing process.

Each of the elements 115 is configured to realize a certain function when a voltage is applied between the first electrodes 120 and the second electrodes 140 or when a current flows between the first electrodes 120 and the second electrodes 140. For example, when the elements 115 are pixels of an organic EL display device, the elements 115 can emit light that constitutes an image.

The first electrodes 120 contain an electrically conductive material. For example, the first electrodes 120 contain metal, a conductive metal oxide, another conductive inorganic material, or the like. The first electrodes 120 may contain a metal oxide having transparency and conductivity, such as indium tin oxide.

The organic layers 130 contain an organic material. When the organic layers 130 are energized, the organic layers 130 can perform a certain function. The "energization" means that a voltage is applied to the organic layers 130 or a current flows through the organic layers 130. Examples of the organic layers 130 may include a light-emitting layer that emits light upon energization, or layers whose light transmittance or refractive index changes with energization. The organic layers 130 may contain an organic semiconductor material.

As illustrated in Fig. 1, the organic layers 130 may include first organic layers 130A and second organic layers 130B. The first organic layers 130A are included in the first elements 115A. The second organic layers 130B are included in the second elements 115B. Although not illustrated, the organic layers 130 may include third organic layers included in the third elements. The first organic layers 130A, the second organic layers 130B, and the third organic layers are, for example, red light-emitting layers, blue light-emitting layers, and green light-emitting layers, respectively.

When a voltage is applied between the first electrodes 120 and the second electrodes 140, the organic layers 130 positioned between them are driven. When the organic layers 130 are a light-emitting layers, light is emitted from the organic layers 130, and the light exits from the second electrodes 140 or the first electrode s 120 to the outside.

The organic layers 130 may further include a hole injection layer, a hole transport layer, an electron transport layer, an electron injection layer, and the like.

The second electrodes 140 may contain an electrically conductive material, such as metal. Examples of materials for the second electrodes 140 may include platinum, gold, silver, copper, iron, tin, chromium, aluminum, indium, lithium, sodium, potassium, calcium, magnesium, chromium, carbon, or the like, or an alloy thereof. As illustrated in Fig. 1, the second electrodes 140 may extend across two organic layers 130 that are disposed next to each other in plan view.

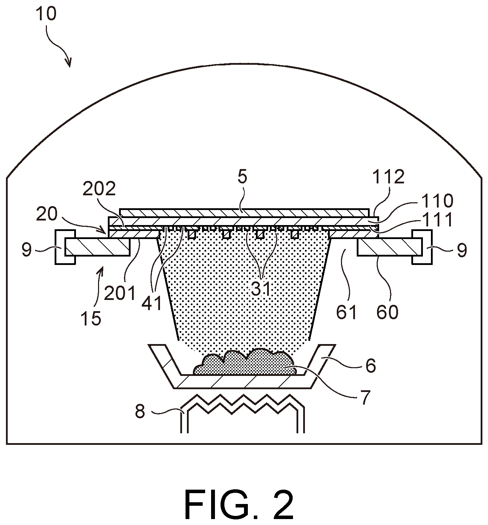

Next, a method for forming the organic layers 130 on the substrate 110 by a vapor deposition method will be described. Fig. 2 is a view illustrating a vapor deposition apparatus 10. The vapor deposition apparatus 10 performs a vapor deposition process for depositing a vapor deposition material on an object.

As illustrated in Fig. 2, the vapor deposition apparatus 10 may include a vapor deposition source 6, a heater 8, and a framed mask 15 therein. The vapor deposition apparatus 10 may further include evacuation means for creating a vacuum atmosphere inside the vapor deposition apparatus 10. The vapor deposition source 6 is, for example, a crucible. The vapor deposition source 6 contains a vapor deposition material 7 such as an organic material or a metal material. The heater 8 heats the vapor deposition source 6 to evaporate the vapor deposition material 7 under the vacuum atmosphere.

The framed mask 15 includes a mask 20 and a frame 60 attached to the mask 20. The framed mask 15 is also referred to as a mask assembly 15. The mask 20 includes an entrance surface 201, an exit surface 202, and second openings 41. The exit surface 202 is located on a side opposite to the entrance surface 201. The mask assembly 15 is supported by a mask holder 9. The mask assembly 15 is disposed such that the entrance surface 201 faces the vapor deposition source 6 and the exit surface 202 faces the first surface 111 of the substrate 110. A part of the vapor deposition material 7 that has entered the mask 20 from the entrance surface 202 passes through the second openings 41 and exits from the exit surface 202. The vapor deposition material 7 exited from the exit surface 202 adheres to the first surface 111 of the substrate 110. The exit surface 202 of the mask 20 may be in contact with the first surface 111 of the substrate 110.

As illustrated in Fig. 2, the vapor deposition apparatus 10 may include a magnet 5 disposed on a second surface 112 side of the substrate 110. When the mask 20 contains a metal material, the magnet 5 can attract the mask 20 toward the substrate 110 by a magnetic force, thereby making it possible to reduce or eliminate a gap between the mask 20 and the substrate 110. As a result, occurrence of a shadow in the vapor deposition step can be suppressed. In the present application, the term "shadow" refers to a phenomenon in which the organic layer 130 formed in a second opening 41 has a smaller thickness in the vicinity of a wall surface of the second opening 41 than at the center of the same second opening 41. The shadow occurs due to, for example, adhesion of the vapor deposition material 7 to the wall surface of the mask 20 or entry of the vapor deposition material 7 into the gap between the mask 20 and the substrate 110.

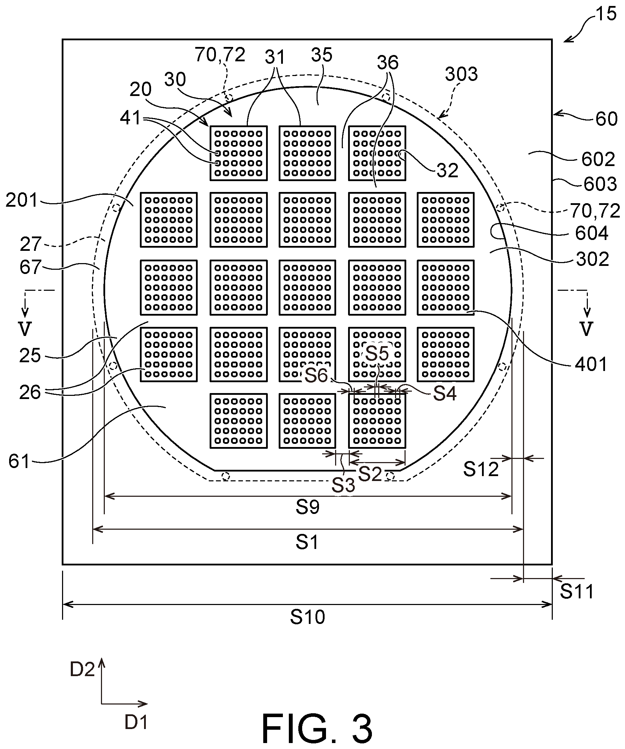

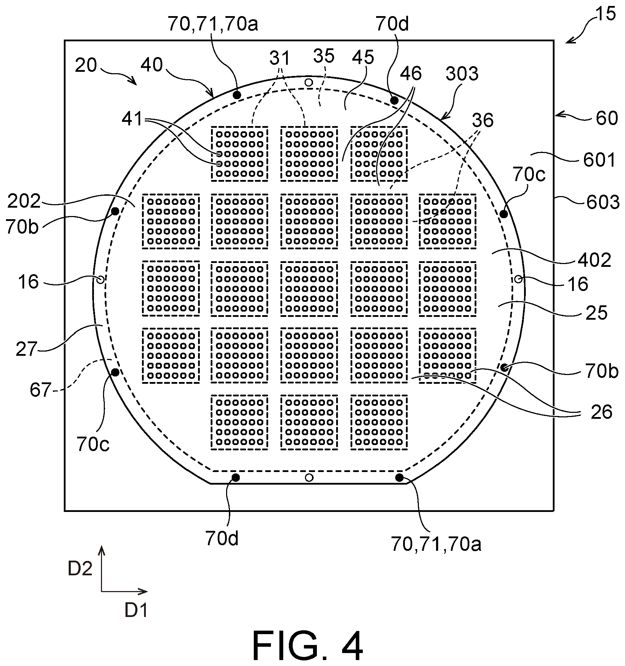

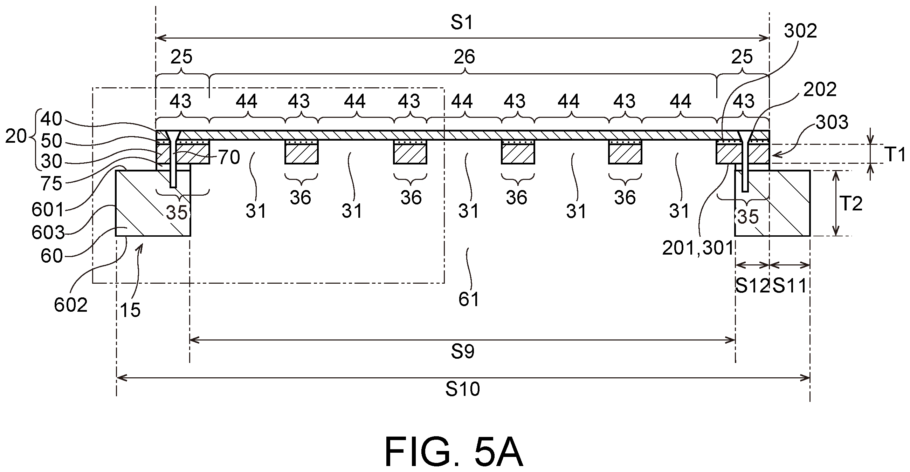

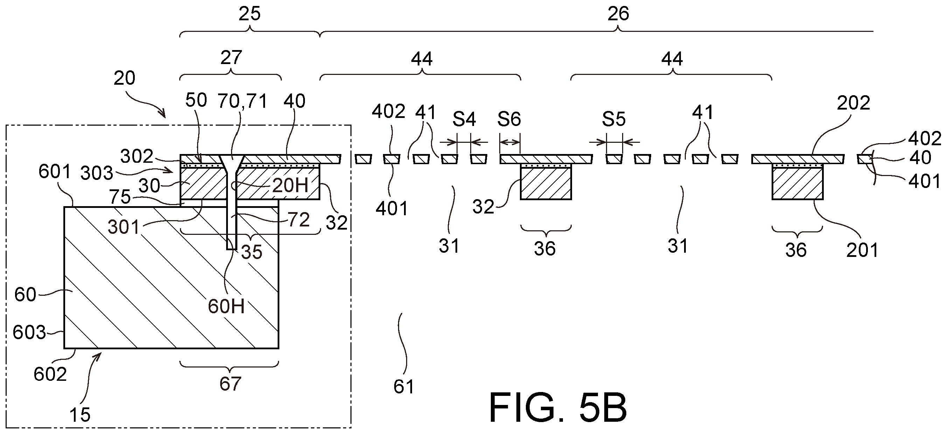

Next, the mask assembly 15 will be described in detail. Fig. 3 is a plan view illustrating an example of the mask assembly 15 as viewed from the entrance surface 201 side. Fig. 4 is a plan view illustrating an example of the mask assembly 15 as viewed from the exit surface 202 side. Fig. 5A is a cross-sectional view of the mask assembly 15 in Fig. 3 taken along line V-V. Fig. 5B is an enlarged view of a portion enclosed by the two-dot chain line in the cross section of Fig. 5A.

First, the mask 20 will be described in detail. As illustrated in Fig. 5A, the mask 20 includes a first layer 30 and a second layer 40 arranged in this order from the entrance surface 201 toward the exit surface 202. The first layer 30 contains, for example, silicon, a silicon compound, glass, or aluminum oxide (Al2O₃). The silicon compound is, for example, silicon carbide (SiC). The second layer 40 contains, for example, a resin material. As illustrated in Fig. 5A, the mask 20 may further include an intermediate layer 50. The intermediate layer 50 is disposed between the first layer 30 and the second layer 40. Hereinafter, each layer will be described.

As well illustrated in Fig. 5B, the first layer 30 includes a first surface 301, a second surface 302, a first opening 31, and a first wall surface 32. The first surface 301 may constitute the entrance surface 201. The second surface 302 is located on the opposite side of the first surface 301.

The first opening 31 penetrates through the first layer 30 from the first surface 301 to the second surface 302. As illustrated in Fig. 3, the first layer 30 may include a plurality of first openings 31. The plurality of first openings 31 may be arranged in a first direction D1 and a second direction D2. The second direction D2 may be orthogonal to the first direction D1.

Each first opening 31 may correspond to one screen of an organic EL display device. The mask 20 illustrated in Fig. 3 can simultaneously form patterns of the organic layers corresponding to a plurality of screens on the substrate 110. As illustrated in Fig. 3, each of the first openings 31 may have a rectangular outline in plan view.

The first wall surface 32 is a surface of the first layer 30 facing the first opening 31. In the example illustrated in Fig. 3, the first wall surface 32 extends in the normal direction of the first surface 301.

As illustrated in Fig. 3, a region of the first layer 30 where the first openings 31 are not formed may include an outer region 35 and an inner region 36. The inner region 36 is a region located between two adjacent first openings 31 in plan view. The outer region 35 is a region located between an outer edge 303 of the first layer 30 and the first openings 31 in plan view. As illustrated in Fig. 3, the inner region 36 may extend in the first direction D1 and the second direction D2.

In the case where the first layer 30 contains silicon or a silicon compound, the first layer 30 may be fabricated by processing a silicon wafer, for example. As illustrated in Fig. 3, the outer edge 303 of the first layer 30 may include a straight portion. The straight portion is also referred to as an orientation flat. Although not illustrated, a cutout may be formed in the outer edge 303. The cutout is also referred to as a notch. When the first layer 30 is fabricated by processing a silicon wafer, the orientation flat and the notch represent the crystal orientation of the silicon wafer.

A maximum dimension S1 of the first layer 30 in plan view may be, for example, 100 mm or more, 150 mm or more, or 200 mm or more. The dimension S1 may be, for example, 300 mm or less, 400 mm or less, or 500 mm or less. The range of the dimension S1 may be defined by a first group consisting of 100 mm, 150 mm, and 200 mm and/or a second group consisting of 300 mm, 400 mm, and 500 mm. The range of the dimension S1 may be defined by a combination of any one of the values included in the first group described above and any one of the values included in the second group described above. The range of the dimension S1 may be defined by a combination of any two of the values included in the first group described above. The range of the dimension S1 may be defined by a combination of any two of the values included in the second group described above. The dimension S1 may be, for example, 100 mm or more and 500 mm or less, 100 mm or more and 400 mm or less, 100 mm or more and 300 mm or less, 100 mm or more and 200 mm or less, 100 mm or more and 150 mm or less, 150 mm or more and 500 mm or less, 150 mm or more and 400 mm or less, 150 mm or more and 300 mm or less, 150 mm or more and 200 mm or less, 200 mm or more and 500 mm or less, 200 mm or more and 400 mm or less, 200 mm or more and 300 mm or less, 300 mm or more and 500 mm or less, 300 mm or more and 400 mm or less, or 400 mm or more and 500 mm or less.

A dimension S2 of each first opening 31 in a direction in which the first openings 31 are arranged may be, for example, 3 mm or more, 10 mm or more, or 20 mm or more. The dimension S2 may be, for example, 30 mm or less, 50 mm or less, or 100 mm or less. The range of the dimension S2 may be defined by a first group consisting of 3 mm, 10 mm, and 20 mm and/or a second group consisting of 30 mm, 50 mm, and 100 mm. The range of the dimension S2 may be defined by a combination of any one of the values included in the first group described above and any one of the values included in the second group described above. The range of the dimension S2 may be defined by a combination of any two of the values included in the first group described above. The range of the dimension S2 may be defined by a combination of any two of the values included in the second group described above. The dimension S2 may be, for example, 3 mm or more and 100 mm or less, 3 mm or more and 50 mm or less, 3 mm or more and 30 mm or less, 3 mm or more and 20 mm or less, 3 mm or more and 10 mm or less, 10 mm or more and 100 mm or less, 10 mm or more and 50 mm or less, 10 mm or more and 30 mm or less, 10 mm or more and 20 mm or less, 20 mm or more and 100 mm or less, 20 mm or more and 50 mm or less, 20 mm or more and 30 mm or less, 30 mm or more and 100 mm or less, 30 mm or more and 50 mm or less, or 50 mm or more and 100 mm or less.

A spacing S3 between two adjacent first openings 31 in the direction in which the first openings 31 are arranged may be, for example, 0.1 mm or more, 0.5 mm or more, or 1.0 mm or more. The spacing S3 may be, for example, 10 mm or less, 15 mm or less, or 20 mm or less. The range of the spacing S3 may be defined by a first group consisting of 0.1 mm, 0.5 mm, and 1.0 mm and/or a second group consisting of 10 mm, 15 mm, and 20 mm. The range of the spacing S3 may be defined by a combination of any one of the values included in the first group described above and any one of the values included in the second group described above. The range of the spacing S3 may be defined by a combination of any two of the values included in the first group described above. The range of the spacing S3 may be defined by a combination of any two of the values included in the second group described above. The spacing S3 may be, for example, 0.1 mm or more and 20 mm or less, 0.1 mm or more and 15 mm or less, 0.1 mm or more and 10 mm or less, 0.1 mm or more and 1.0 mm or less, 0.1 mm or more and 0.5 mm or less, 0.5 mm or more and 20 mm or less, 0.5 mm or more and 15 mm or less, 0.5 mm or more and 10 mm or less, 0.5 mm or more and 1.0 mm or less, 1.0 mm or more and 20 mm or less, 1.0 mm or more and 15 mm or less, 1.0 mm or more and 10 mm or less, 10 mm or more and 20 mm or less, 10 mm or more and 15 mm or less, or 15 mm or more and 20 mm or less.

The thickness of the first layer 30 is defined as a maximum thickness T1 of the outer region 35. The thickness T1 may be, for example, 50 µm or more, 100 µm or more, or 200 µm or more. The thickness T1 may be, for example, 600 µm or less, 800 µm or less, or 1000 µm or less. The range of the thickness T1 may be defined by a first group consisting of 50 µm, 100 µm, and 200 µm and/or a second group consisting of 600 µm, 800 µm, and 1000 µm. The range of the thickness T1 may be defined by a combination of any one of the values included in the first group described above and any one of the values included in the second group described above. The range of the thickness T1 may be defined by a combination of any two of the values included in the first group described above. The range of the thickness T1 may be defined by a combination of any two of the values included in the second group described above. The thickness T1 may be, for example, 50 µm or more and 1000 µm or less, 50 µm or more and 800 µm or less, 50 µm or more and 600 µm or less, 50 µm or more and 200 µm or less, 50 µm or more and 100 µm or less, 100 µm or more and 1000 µm or less, 100 µm or more and 800 µm or less, 100 µm or more and 600 µm or less, 100 µm or more and 200 µm or less, 200 µm or more and 1000 µm or less, 200 µm or more and 800 µm or less, 200 µm or more and 600 µm or less, 600 µm or more and 1000 µm or less, 600 µm or more and 800 µm or less, or 800 µm or more and 1000 µm or less.

Next, the second layer 40 will be described. The second layer 40 includes a third surface 401, a fourth surface 402, and a plurality of second openings 41. The third surface 401 faces toward the second surface 302 of the first layer 30. The fourth surface 402 is located on the opposite side of the second layer from the third surface 401.

The second openings 41 penetrate through the second layer 40 from the third surface 401 to the fourth surface 402. One second opening 41 corresponds to one organic layer 130. One group of a plurality of regularly arranged second openings 41 corresponds to one screen of the organic EL display device. As illustrated in Figs. 3 and 4, one group of a plurality of regularly arranged second openings 41 may overlap one first opening 31 in plan view. A plurality of groups of the second openings 41 are supported by the first layer 30 formed by processing a single member such as a silicon wafer.

The second layer 40 may include a peripheral region 43 and an effective region 44. The peripheral region 43 is a region that overlaps the first layer 30 in plan view. The effective region 44 is a region in which one group of a plurality of regularly arranged second openings 41 is distributed. The peripheral region 43 may include an outer region 45 and an inner region 46. The outer region 45 is a region that overlaps the outer region 35 of the first layer 30 in plan view. The inner region 46 is a region that overlaps the inner region 36 of the first layer 30 in plan view.

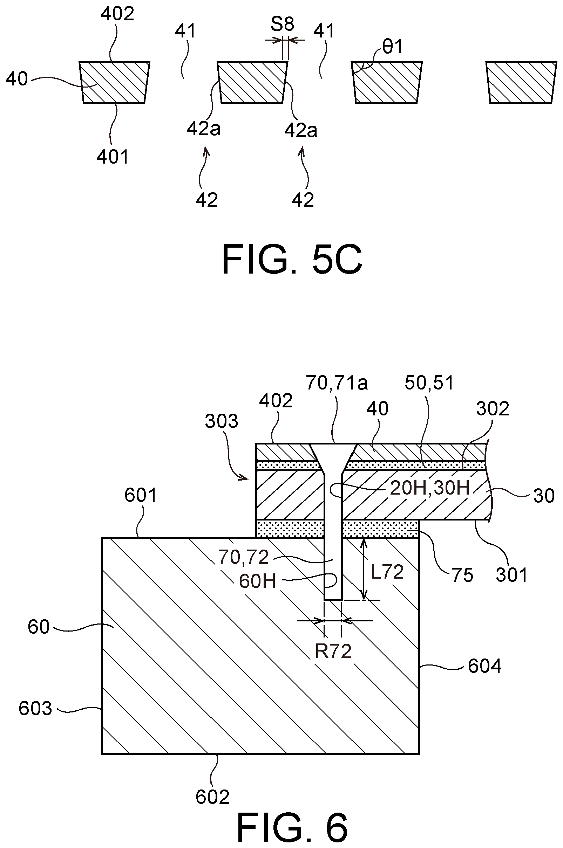

Fig. 5C is a cross-sectional view illustrating an example of the effective region 44. The second layer 40 includes second wall surfaces 42 facing the second openings 41. As illustrated in Fig. 5C, each of the second wall surfaces 42 may include a tapered surface 42a that widens away from the center of the corresponding second opening 41 toward the third surface 401. Since the second wall surface 42 includes the tapered surface 42a, occurrence of a shadow in the vicinity of the second wall surface 42 can be suppressed.

In Fig. 5C, reference sign S8 represents a width of the tapered surface 42a in a direction in which the second openings 41 are arranged. The width S8 may be, for example, 0.1 µm or more, 0.5 µm or more, or 1.0 µm or more. The width S8 may be, for example, 10 µm or less, 20 µm or less, or 25 µm or less. The range of the width S8 may be defined by a first group consisting of 0.1 µm, 0.5 µm, and 1.0 µm and/or a second group consisting of 10 µm, 20 µm, and 25 µm. The range of the width S8 may be defined by a combination of any one of the values included in the first group described above and any one of the values included in the second group described above. The range of the width S8 may be defined by a combination of any two of the values included in the first group described above. The range of the width S8 may be defined by a combination of any two of the values included in the second group described above. The width S8 may be, for example, 0.1 µm or more and 25 µm or less, 0.1 µm or more and 20 µm or less, 0.1 µm or more and 10 µm or less, 0.1 µm or more and 1.0 µm or less, 0.1 µm or more and 0.5 µm or less, 0.5 µm or more and 25 µm or less, 0.5 µm or more and 20 µm or less, 0.5 µm or more and 10 µm or less, 0.5 µm or more and 1.0 µm or less, 1.0 µm or more and 25 µm or less, 1.0 µm or more and 20 µm or less, 1.0 µm or more and 10 µm or less, 10 µm or more and 25 µm or less, 10 µm or more and 20 µm or less, or 20 µm or more and 25 µm or less.

In Fig. 5C, reference sign θ1 represents an angle formed by the second wall surface 42 and the fourth surface 402. The angle θ1 may be, for example, 50° or more, 55° or more, or 60° or more. The angle θ1 may be, for example, 80° or less, 85° or less, or less than 90°. The range of the angle θ1 may be defined by a first group consisting of 50°, 55°, and 60° and/or a second group consisting of 80°, 85°, and 90°. The range of the angle θ1 may be defined by a combination of any one of the values included in the first group described above and any one of the values included in the second group described above. The range of the angle θ1 may be defined by a combination of any two of the values included in the first group described above. The range of the angle θ1 may be defined by a combination of any two of the values included in the second group described above. The angle θ1 may be, for example, 50° or more and less than 90°, 50° or more and 85° or less, 50° or more and 80° or less, 50° or more and 60° or less, 50° or more and 55° or less, 55° or more and less than 90°, 55° or more and 85° or less, 55° or more and 80° or less, 55° or more and 60° or less, 60° or more and less than 90°, 60° or more and 85° or less, 60° or more and 80° or less, 80° or more and less than 90°, 80° or more and 85° or less, or 85° or more and less than 90°.

The second layer 40 may contain a metal material. When the second layer 40 contains a metal material, the mask 20 can be brought into close contact with the substrate 110 by using the magnet 5. In this case, the mask 20 can be attracted toward the magnet 5 by a magnetic force, thereby bringing the mask 20 into closer contact with the substrate 110. As a result, it is possible to improve the definition of the organic layers 130A, 130B, and 130C of the organic device 100.

The metal material contained in the second layer 40 may be a magnetic metal material. The magnetic metal material may be, for example, nickel, iron, cobalt, or an alloy thereof. For example, an iron alloy containing nickel may be used as the material constituting the second layer 40. The iron alloy may further contain cobalt in addition to nickel. For example, as the material of the second layer 40, an iron alloy in which the total content of nickel and cobalt is 30 mass% or more and 54 mass% or less, and the content of cobalt is 0 mass% or more and 6 mass% or less may be used. As the iron alloy containing nickel, an Invar material containing 34 mass% or more and 38 mass% or less of nickel, a low thermal expansion Fe-Ni based plating alloy containing 38 mass% or more and 54 mass% or less of nickel, or the like may be used. As the iron alloy containing nickel and cobalt, for example, a Super Invar material containing cobalt in addition to 30 mass% or more and 34 mass% or less of nickel may be used. By using such an iron alloy, the coefficient of thermal expansion of the second layer 40 can be reduced. For example, in the case where a glass substrate is used as the substrate 110, the coefficient of thermal expansion of the second layer 40 can be adjusted to a value equal to or close to that of the glass substrate. Therefore, a degradation of the definition can be suppressed.

As the material constituting the second layer 40, a nickel alloy containing cobalt may be used. In the case of using a nickel alloy containing cobalt, a nickel alloy having a cobalt content of 8 mass% or more and 10 mass% or less may be used as the material of the second layer 40. When such nickel or a nickel alloy is used, decomposition of components of a plating solution used in a second layer forming step described later can be suppressed, and stability of the plating solution can be improved.

The second layer 40 may be formed of a single metal layer or may include a plurality of metal layers. When the mask 20 includes the intermediate layer 50, the second layer 40 is made of a material having resistance to an etchant for etching the intermediate layer 50.

The thickness of the second layer 40 is smaller than the thickness T1 of the first layer 30. The thickness of the second layer 40 may be, for example, 0.5 µm or more, 1.0 µm or more, or 2.0 µm or more. The thickness of the second layer 40 may be, for example, 5 µm or less, 10 µm or less, or 25 µm or less. The range of the thickness of the second layer 40 may be defined by a first group consisting of 0.5 µm, 1.0 µm, and 2.0 µm and/or a second group consisting of 5 µm, 10 µm, and 25 µm. The range of the thickness of the second layer 40 may be defined by a combination of any one of the values included in the first group described above and any one of the values included in the second group described above. The range of the thickness of the second layer 40 may be defined by a combination of any two of the values included in the first group described above. The range of the thickness of the second layer 40 may be defined by a combination of any two of the values included in the second group described above. The thickness of the second layer 40 may be, for example, 0.5 µm or more and 25 µm or less, 0.5 µm or more and 10 µm or less, 0.5 µm or more and 5 µm or less, 0.5 µm or more and 2.0 µm or less, 0.5 µm or more and 1.0 µm or less, 1.0 µm or more and 25 µm or less, 1.0 µm or more and 10 µm or less, 1.0 µm or more and 5 µm or less, 1.0 µm or more and 2.0 µm or less, 2.0 µm or more and 25 µm or less, 2.0 µm or more and 10 µm or less, 2.0 µm or more and 5 µm or less, 5 µm or more and 25 µm or less, 5 µm or more and 10 µm or less, or 10 µm or more and 25 µm or less. When the thickness of the second layer 40 is 25 µm or less, occurrence of a shadow can be suppressed. When the thickness of the second layer 40 is 0.5 µm or more, occurrence of, for example, defects such as pinholes and deformation in the second layer 40 can be suppressed.

A dimension S4 of each of the second openings 41 in plan view may be, for example, 1 µm or more, 2 µm or more, or 3 µm or more. The dimension S4 may be, for example, 5 µm or less, 10 µm or less, or 25 µm or less. The range of the dimension S4 may be defined by a first group consisting of 1 µm, 2 µm, and 3 µm and/or a second group consisting of 5 µm, 10 µm, and 25 µm. The range of the dimension S4 may be defined by a combination of any one of the values included in the first group described above and any one of the values included in the second group described above. The range of the dimension S4 may be defined by a combination of any two of the values included in the first group described above. The range of the dimension S4 may be defined by a combination of any two of the values included in the second group described above. The dimension S4 may be, for example, 1 µm or more and 25 µm or less, 1 µm or more and 10 µm or less, 1 µm or more and 5 µm or less, 1 µm or more and 3 µm or less, 1 µm or more and 2 µm or less, 2 µm or more and 25 µm or less, 2 µm or more and 10 µm or less, 2 µm or more and 5 µm or less, 2 µm or more and 3 µm or less, 3 µm or more and 25 µm or less, 3 µm or more and 10 µm or less, 3 µm or more and 5 µm or less, 5 µm or more and 25 µm or less, 5 µm or more and 10 µm or less, or 10 µm or more and 25 µm or less.

An spacing S5 between two second openings 41 in a direction in which the second openings 41 are arranged may be, for example, 1 µm or more, 2 µm or more, or 3 µm or more. The spacing S5 may be, for example, 5 µm or less, 10 µm or less, or 25 µm or less. The range of the spacing S5 may be defined by a first group consisting of 1 µm, 2 µm, and 3 µm and/or a second group consisting of 5 µm, 10 µm, and 25 µm. The range of the spacing S5 may be defined by a combination of any one of the values included in the first group described above and any one of the values included in the second group described above. The range of the spacing S5 may be defined by a combination of any two of the values included in the first group described above. The range of the spacing S5 may be defined by a combination of any two of the values included in the second group described above. The spacing S5 may be, for example, 1 µm or more and 25 µm or less, 1 µm or more and 10 µm or less, 1 µm or more and 5 µm or less, 1 µm or more and 3 µm or less, 1 µm or more and 2 µm or less, 2 µm or more and 25 µm or less, 2 µm or more and 10 µm or less, 2 µm or more and 5 µm or less, 2 µm or more and 3 µm or less, 3 µm or more and 25 µm or less, 3 µm or more and 10 µm or less, 3 µm or more and 5 µm or less, 5 µm or more and 25 µm or less, 5 µm or more and 10 µm or less, or 10 µm or more and 25 µm or less.

An spacing S6 between the first wall surface 32 and the second opening 41 in plan view may be larger than the spacing S5. As a result, it is possible to suppress occurrence of shadows in second openings 41 close to the first wall surface 32.

Next, the intermediate layer 50 will be described. The intermediate layer 50 includes a layer that performs a certain function with respect to the first layer 30 or the second layer 40. For example, the intermediate layer 50 may function as a stopper layer that stops etching in a step of processing the first layer 30 by etching. When the intermediate layer 50 is a stopper layer, the intermediate layer 50 may contain aluminum, an aluminum alloy, titanium, or a titanium alloy. When the intermediate layer 50 is a stopper layer, the intermediate layer 50 may contain an inorganic compound such as silicon oxide. Alternatively, the intermediate layer 50 may function to bond the first layer 30 and the second layer 40. For example, the intermediate layer 50 may be a bonding layer containing an adhesive.

The thickness of the intermediate layer 50 is not particularly limited as long as the above-described function can be exhibited. For example, the thickness of the intermediate layer 50 may be smaller than the thickness of the second layer 40 or may be equal to or larger than the thickness of the second layer 40. The thickness of the intermediate layer 50 may be, for example, 5 nm or more, 50 nm or more, or 75 nm or more. The thickness of the intermediate layer 50 may be, for example, 1 µm or less, 10 µm or less, or 100 µm or less. The range of the thickness of the intermediate layer 50 may be defined by a first group consisting of 5 nm, 50 nm, and 75 nm and/or a second group consisting of 1 µm, 10 µm, and 100 µm. The range of the thickness of the intermediate layer 50 may be defined by a combination of any one of the values included in the first group described above and any one of the values included in the second group described above. The range of the thickness of the intermediate layer 50 may be defined by a combination of any two of the values included in the first group described above. The range of the thickness of the intermediate layer 50 may be defined by a combination of any two of the values included in the second group described above. The thickness of the intermediate layer 50 may be, for example, 5 nm or more and 100 µm or less, 5 nm or more and 10 µm or less, 5 nm or more and 1 µm or less, 5 nm or more and 75 nm or less, 5 nm or more and 50 nm or less, 50 nm or more and 100 µm or less, 50 nm or more and 10 µm or less, 50 nm or more and 1 µm or less, 50 nm or more and 75 nm or less, 75 nm or more and 100 µm or less, 75 nm or more and 10 µm or less, 75 nm or more and 1 µm or less, 1 µm or more and 100 µm or less, 1 µm or more and 10 µm or less, or 10 µm or more and 100 µm or less.

Preferably, the intermediate layer 50 is positioned so as not to overlap the second openings 41 in plan view, thereby suppressing occurrence of shadows due to the intermediate layer 50.

In the mask 20 described above, a region including the regions where the first openings 31 are formed, the regions where the second openings 41 are formed (the effective region 44), and the inner regions 36 and 46 is hereinafter also referred to as an inner region 26 of the mask 20. A region including the outer regions 35 and 45 is also referred to as an outer region 25 of the mask 20. The outer region 25 surrounds the inner region 26. The outer region 25 includes a connection region 27 to which the frame 60 is connected. The connection region 27 is an outer edge region of the outer region 25.

Next, the frame 60 will be described in detail. The frame 60 is attached to the mask 20 for the purpose of being gripped when the mask 20 is handled, for example, when the mask 20 is moved. As illustrated in, for example, Fig. 3, the second openings 41, and thus the first openings 31, are formed in the mask 20 up to the vicinity of the outer edge of the mask 20. In general, when the mask 20 is handled, for example, when the mask 20 is moved, it is desirable to grip the outer region 35 of the first layer 30 to prevent, for example, deformation of the second openings 41 of the second layer 40 or to prevent contamination of the second layer 40. However, when the first openings 31 are formed up to the vicinity of the outer edge 303 of the first layer 30, the area of the outer region 35 is insufficient to grip the outer region 35. In addition, when the first openings 31 are formed up to the vicinity of the outer edge 303 of the first layer 30, the outer region 35 is narrow. The narrow outer region 35 is likely to be damaged. The outer region 35 is particularly likely to be damaged when the first layer 30 contains silicon or a silicon compound. By attaching the frame 60 to the outer region 25 of the mask 20 as described above, the frame 60 can be gripped when the mask 20 is handled, and the possibility of damage to the first layer 30 can be reduced. As a result, handling of the mask 20 is facilitated.

As understood from Figs. 3 to 5B, the frame 60 includes a fifth surface 601 and a sixth surface 602. The fifth surface 601 faces in the same direction as the fourth surface 402. The sixth surface 602 is located opposite to the fifth surface 601. In the illustrated example, the fifth surface 601 faces toward the first surface 301.

As illustrated in Figs. 5A and 5B, the mask 20 is fixed to the frame 60 by one or more screws 70. The frame 60 faces toward the first surface 301 of the outer region 35 of the first layer 30. In the illustrated example, a buffer material 75 is disposed between the first surface 301 of the outer region 35 and the fifth surface 601 of the frame 60. The frame 60 faces toward the first layer 30 with the buffer material 75 interposed therebetween. In plan view, the frame 60 does not overlap the first openings 31. In plan view, at least a part of the frame 60 extends outward beyond the outer edge 303 of the first layer 30. Thus, the frame 60 provides an extended region for gripping when the mask 20 is handled.

The frame 60 contains a glass material or a metal material. The glass material is quartz glass, borosilicate glass, alkali-free glass, soda glass, or the like. The metal material is an Invar material or stainless steel such as SUS430 or SUS304. When the frame 60 contains these materials, the rigidity of the frame 60 can be made greater than that of the first layer 30. The material of the frame 60 may be determined so that the frame 60 has required rigidity, in consideration of a gripping force of an operator or a robot hand that handles the mask assembly 15.

The coefficient of linear thermal expansion of the frame 60 is preferably substantially the same as the coefficient of linear thermal expansion of the first layer 30. In this case, when the mask assembly 15 is heated, the elongation rates of the frame 60 and the first layer 30 can be made substantially the same. As a result, the possibility of damage to the first layer 30 is suppressed. Specifically, the absolute value of the difference between the coefficient of linear thermal expansion of the frame 60 and the coefficient of linear thermal expansion of the first layer 30 is 15 ppm/°C or less, and may be 10 ppm/°C or less, or 5.0 ppm/°C or less.

In the illustrated example, the frame 60 is formed in an annular shape. The frame 60 has a region extending circumferentially outside the outer edge 303 of the first layer 30 in plan view. Therefore, the possibility that the outer region 35 of the first layer 30 is damaged when the mask 20 is handled is effectively suppressed. More specifically, the frame 60 has, at its center, a third opening 61 penetrating from the fifth surface 601 to the sixth surface 602. In the illustrated example, the third opening 61 has a shape similar to that of the outer edge 303 of the first layer 30. A maximum dimension S9 of the third opening 61 is smaller than the maximum dimension S1 of the outer edge 303 of the first layer 30. In plan view, the third opening 61 overlaps the inner region 26 of the mask 20.

The shape and dimension of an outer edge 603 of the frame 60 are not particularly limited. The shape and dimension S10 of the outer edge 603 of the frame 60 may be determined in consideration of the dimensions and shape of the hand of the operator or the robot hand that handles the mask assembly 15, and the dimensions and shape of the mask holder 9 of the vapor deposition apparatus 10. The outer edge 603 of the frame 60 may have a quadrangular shape or another polygonal shape. The dimension S10 of the outer edge 603 of the frame 60 may be, for example, 100 mm or more, 150 mm or more, or 200 mm or more. The dimension S10 may be, for example, 300 mm or less, 400 mm or less, or 500 mm or less. The range of the dimension S10 may be defined by a first group consisting of 100 mm, 150 mm, and 200 mm and/or a second group consisting of 300 mm, 400 mm, and 500 mm. The range of the dimension S10 may be defined by a combination of any one of the values included in the first group described above and any one of the values included in the second group described above. The range of the dimension S10 may be defined by a combination of any two of the values included in the first group described above. The range of the dimension S10 may be defined by a combination of any two of the values included in the second group described above. The dimension S10 may be, for example, 100 mm or more and 500 mm or less, 100 mm or more and 400 mm or less, 100 mm or more and 300 mm or less, 100 mm or more and 200 mm or less, 100 mm or more and 150 mm or less, 150 mm or more and 500 mm or less, 150 mm or more and 400 mm or less, 150 mm or more and 300 mm or less, 150 mm or more and 200 mm or less, 200 mm or more and 500 mm or less, 200 mm or more and 400 mm or less, 200 mm or more and 300 mm or less, 300 mm or more and 500 mm or less, 300 mm or more and 400 mm or less, or 400 mm or more and 500 mm or less.

A distance S11 between the outer edge 603 of the frame 60 and the outer edge 303 of the first layer 30 may also be determined in consideration of the dimensions and shape of the hand of the operator or the robot hand that handles the mask assembly 15, and the dimensions and shape of the mask holder 9 of the vapor deposition apparatus 10. The distance S11 may be, for example, 5 mm or more, 10 mm or more, or 15 mm or more. The distance S11 may be, for example, 30 mm or less, 60 mm or less, or 100 mm or less. The range of the distance S11 may be defined by a first group consisting of 5 mm, 10 mm, and 15 mm and/or a second group consisting of 30 mm, 60 mm, and 100 mm. The range of the distance S11 may be defined by a combination of any one of the values included in the first group described above and any one of the values included in the second group described above. The range of the distance S11 may be defined by a combination of any two of the values included in the first group described above. The range of the distance S11 may be defined by a combination of any two of the values included in the second group described above. The distance S11 may be, for example, 5 mm or more and 100 mm or less, 5 mm or more and 60 mm or less, 5 mm or more and 30 mm or less, 5 mm or more and 15 mm or less, 5 mm or more and 10 mm or less, 10 mm or more and 100 mm or less, 10 mm or more and 60 mm or less, 10 mm or more and 30 mm or less, 10 mm or more and 15 mm or less, 15 mm or more and 100 mm or less, 15 mm or more and 60 mm or less, 15 mm or more and 30 mm or less, 30 mm or more and 100 mm or less, 30 mm or more and 60 mm or less, or 60 mm or more and 100 mm or less.

As illustrated in Fig. 5B, the frame 60 includes, around the third opening 61, a connection region 67 to which the mask 20 is connected. The connection region 67 overlaps the connection region 27 of the mask 20 in plan view. A width S12 of the connection regions 27 and 67 may be, for example, 1 mm or more, 5 mm or more, or 10 mm or more. The width S12 may be, for example, 20 mm or less, 25 mm or less, or 30 mm or less. The range of the width S12 may be defined by a first group consisting of 1 mm, 5 mm, and 10 mm and/or a second group consisting of 20 mm, 25 mm, and 30 mm. The range of the width S12 may be defined by a combination of any one of the values included in the first group described above and any one of the values included in the second group described above. The range of the width S12 may be defined by a combination of any two of the values included in the first group described above. The range of the width S12 may be defined by a combination of any two of the values included in the second group described above. The width S12 may be, for example, 1 mm or more and 30 mm or less, 1 mm or more and 25 mm or less, 1 mm or more and 20 mm or less, 1 mm or more and 10 mm or less, 1 mm or more and 5 mm or less, 5 mm or more and 30 mm or less, 5 mm or more and 25 mm or less, 5 mm or more and 20 mm or less, 5 mm or more and 10 mm or less, 10 mm or more and 30 mm or less, 10 mm or more and 25 mm or less, 10 mm or more and 20 mm or less, 20 mm or more and 30 mm or less, 20 mm or more and 25 mm or less, or 25 mm or more and 30 mm or less.

A thickness T2 of the frame 60 is also not particularly limited. The thickness T2 may also be determined in consideration of the dimensions and shape of the hand of the operator or the robot hand that handles the mask assembly 15, and the dimensions and shape of the mask holder 9 of the vapor deposition apparatus 10. The thickness T2 may be, for example, 500 µm or more, 2 mm or more, or 5 mm or more. The thickness T2 may be, for example, 10 mm or less, 20 mm or less, or 30 mm or less. The range of the thickness T2 may be defined by a first group consisting of 500 µm, 2 mm, and 5 mm and/or a second group consisting of 10 mm, 20 mm, and 30 mm. The range of the thickness T2 may be defined by a combination of any one of the values included in the first group described above and any one of the values included in the second group described above. The range of the thickness T2 may be defined by a combination of any two of the values included in the first group described above. The range of the thickness T2 may be defined by a combination of any two of the values included in the second group described above. The thickness T2 may be, for example, 500 µm or more and 30 mm or less, 500 µm or more and 20 mm or less, 500 µm or more and 10 mm or less, 500 µm or more and 5 mm or less, 500 µm or more and 2 mm or less, 2 mm or more and 30 mm or less, 2 mm or more and 20 mm or less, 2 mm or more and 10 mm or less, 2 mm or more and 5 mm or less, 5 mm or more and 30 mm or less, 5 mm or more and 20 mm or less, 5 mm or more and 10 mm or less, 10 mm or more and 30 mm or less, 10 mm or more and 20 mm or less, or 20 mm or more and 30 mm or less.

By determining the shape and dimension of the outer edge 603 of the frame 60 and the thickness T2 of the frame 60 in consideration of the dimensions and shape of the robot hand that handles the mask assembly 15 and/or the dimensions and shape of the mask holder 9 of the vapor deposition apparatus 10, the shape and dimensions of the mask assembly 15 can be made suitable for the existing robot hand and/or the existing vapor deposition apparatus 10. In other words, it is not necessary to adapt the shape and dimensions of the mask 20 itself to the shape and dimensions of the existing robot hand and/or the existing vapor deposition apparatus 10, and thus the degree of freedom in the design of the mask 20 is improved.

In the illustrated example, the mask 20 protrudes from the fifth surface 601 of the frame 60. As will be described later, the screws 70 do not protrude from the exit surface 202 of the mask 20. Therefore, when forming vapor deposition layers on the substrate 110 or on a component on the substrate 110 through the mask 20, the exit surface 202 of the mask 20 can be brought into contact with the substrate 110 or the component on the substrate 110.

Next, the screws 70 will be described in detail. The screws 70 fix the mask 20 to the frame 60. By fixing the mask 20 to the frame 60 using the screws 70, the mask 20 can be easily connected to the frame 60. It is also easy to detachably connect the mask 20 to the frame 60. When the mask 20 is detachably connected to the frame 60, after the mask assembly 15 is used in a vapor deposition process, the mask 20 can be removed from the frame 60, and the frame 60 can be reused to fabricate a new mask assembly 15. In this regard, the mask assembly 15 used in a vapor deposition process is to be cleaned using an ultrasonic cleaner or the like, and then reused in a subsequent vapor deposition process. However, if cleaning is performed many times, the mask 20 may be deformed or broken, resulting in displacement or deformation of the second openings 41. When a vapor deposition process is performed using such a mask 20, the accuracy of the positions, shapes, and the like of the vapor deposition layers, such as the organic layers 130 or the second electrodes 140, formed on the substrate 110 decreases. Therefore, the mask 20 of the mask assembly 15 that has been used several times needs to be replaced.

As illustrated in Fig. 5B, each screw 70 has a head 71 and a shaft 72. The mask 20 and the frame 60 are stacked in this order in a direction from the head 71 toward the shaft 72 of the screw 70. Each screw 70 is inserted into a screw hole 20H formed in the mask 20 and a hole 60H formed in the frame 60. The screw 70 and the screw holes 20H and 60H extend in the stacking direction of the mask 20 and the frame 60. The screw holes 20H and 60H overlap in the stacking direction of the mask 20 and the frame 60.

The screws 70 are arranged in the connection region 27 of the mask 20 and the connection region 67 of the frame 60. Corresponding to the arrangement of screws 70, screw holes 20H are formed in the connection region 27 of the mask 20. The screw holes 20H penetrate through the mask 20 from the exit surface 202 to the entrance surface 201. The screw holes 60H are formed in the connection region 67 of the frame 60. In the illustrated example, the screw holes 60H are formed as bottomed holes that are open in the fifth surface 601 of the frame 60. However, the screw holes 60H may penetrate through the frame 60 from the fifth surface 601 to the sixth surface 602.

The number of the screws 70 for fixing the mask 20 to the frame 60 is not particularly limited. The number of the screws 70 may be one or more, may be two or more, may be four or more, or may be eight or more. As the number of the screws 70 increases, the flatness of the mask 20 in the mask assembly 15 is improved. In the example illustrated in Fig. 4, the mask 20 is fixed to the frame 60 by one or more pairs of screws 70a and 70a, 70b and 70b, 70c and 70c, and 70d and 70d, the pairs each being arranged with a plurality of second openings 41 interposed therebetween in plan view. Also in this case, the flatness of the mask 20 in the mask assembly 15 is improved. When the flatness of the mask 20 in the mask assembly 15 is improved, the accuracy of the positions, shapes, and the like of the vapor deposition layers, such as the organic layers 130 or the second electrodes 140, on the substrate 110 is improved.

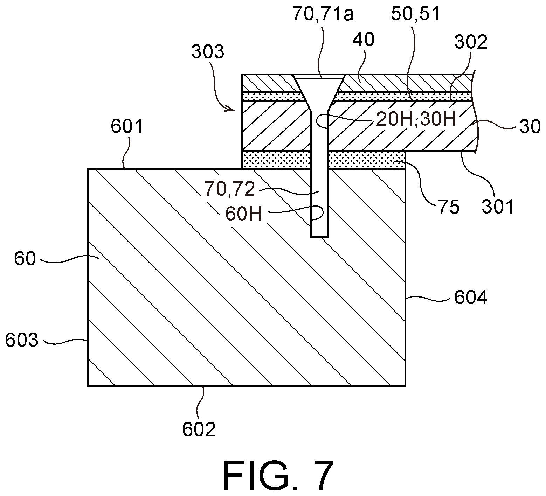

In the example illustrated in Fig. 6, a top surface 71a of the head 71 of the screw 70 is flush with the exit surface 202 of the mask 20. Therefore, the top surface 71a of the head 71 of the screw 70 is flush with the fourth surface 402 of the second layer 40. In this case, when vapor deposition layers are formed on the substrate 110 or a component on the substrate 110 through the mask 20, the exit surface 202 of the mask 20 can be brought into contact with the substrate 110 or the component on the substrate 110. Of course, as illustrated in Fig. 7, the top surface 71a of the head 71 of the screw 70 may be located between the fourth surface 402 of the second layer 40 and the first surface 301 of the first layer 30. In this case as well, the exit surface 202 of the mask 20 can be brought into contact with the substrate 110 or a component on the substrate 110. "Flush" means that two surfaces are located in the same plane.

The screw 70 may contain high-speed steel, hardened steel, stainless steel, a titanium alloy, an aluminum alloy, a nickel alloy, a molybdenum alloy, a tungsten alloy, a ceramic such as alumina or zirconia, a hard plastic, graphite, carbon fibers, or glass. The nickel alloy may be an Invar material. The stainless steel may be SUS430, SUS304, or the like. The glass may be quartz glass, borosilicate glass, alkali-free glass, soda glass, or the like. The screw 70 may be made of the same material as the frame 60. For example, when the frame 60 is made of glass, the screw 70 may also be made of glass. For example, when the frame 60 is made of metal, the screw 70 may also be made of metal. When the screw 70 is made of the same material as the frame 60, the favorable fastening between the screw 70 and the frame 60 can be achieved, and the mask 20 can be firmly fixed to the frame 60.

The shaft 72 of the screw 70 has a portion that extends inside the frame 60, and a ratio L72/R72 of a length L72 of this portion to a diameter R72 of the shaft 72 may be, for example, 1.5 or more, or 2 or more.

Next, the buffer material 75 will be described. The buffer material 75 has a cushioning property. Since the buffer material 75 having a cushioning property is disposed between the mask 20 and the frame 60, the stress applied from the frame 60 to the mask 20 can be absorbed by the buffer material 75. As a result, the possibility of damage to the mask 20 can be reduced. In addition, when unevenness is present on the entrance surface 201 and/or the fifth surface 601 in the connection regions 27 and 67 of the mask 20 and the frame 60, the buffer material 75 deforms to fill the unevenness. Therefore, even if unevenness is present in the connection regions 27 and 67 of the mask 20 and the frame 60, the mask 20 can be connected to the frame 60 so that the exit surface 202 of the mask 20 becomes flat. The buffer material 75 may contain a resin-based or silicon-based elastic material. The buffer material 75 may contain a porous ceramic.

As illustrated in Fig. 4, the mask assembly 15 may include one or more alignment marks 16. The one or more alignment marks 16 are formed, for example, on the exit surface 202 of the mask 20. The one or more alignment marks 16 are used to adjust the relative position of the mask assembly 15 with respect to the substrate 110 (and thus to adjust the relative position of the mask 20 with respect to the substrate 110). When the substrate 110 has a property of transmitting visible light, the one or more alignment marks 16 can be visually recognized through the substrate 110. The one or more alignment marks 16 may be formed in the second layer 40 or in a layer other than the second layer 40. The one or more alignment marks 16 may be located in the outer region 25 of the mask 20 or in the inner region 26 of the mask 20.

As illustrated in Fig. 4, each of the alignment marks 16 may have a circular outline in plan view. Although not illustrated, the alignment mark 16 may have an outline other than a circular shape, such as a rectangular shape or a cross shape.

The thicknesses of the respective layers, the dimensions and spacings of the components, and the like can be measured by observing an image of a cross section of the mask 20 using a scanning electron microscope.

### (Method for manufacturing mask assembly)

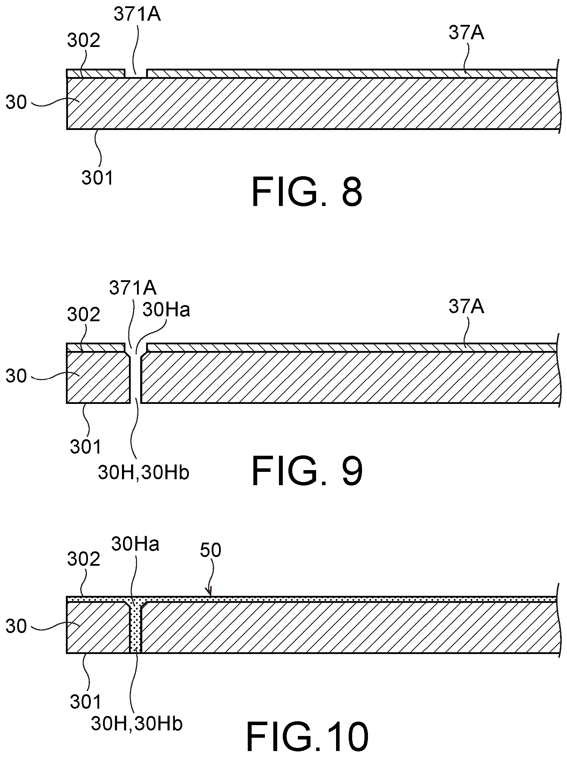

Next, a method for manufacturing a mask assembly according to the present embodiment will be described with reference to Figs. 8 to 21. A method for manufacturing the mask 20 will be described. In this method, a first layer 30 is prepared as an initial step. A silicon wafer may be used as the first layer 30. A first surface 301 and a second surface 302 of the first layer 30 may be mirror-polished. The arithmetic mean roughness Ra of the first surface 301 and the second surface 302 may be 1.5 nm or less, or may be 1.0 nm or less. The plane orientations of the first surface 301 and the second surface 302 may be (100), (110), or the like.

Subsequently, as illustrated in Fig. 8, a resist forming step is performed to partially form a resist layer 37A on the second surface 302 of the first layer 30. The resist layer 37A is formed with one or more resist openings 371A. The one or more resist openings 371A are formed so as to face one or more screw holes 30H. Each screw hole 30H is a portion of a screw hole 20H that extends within the first layer 30.

The resist layer 37A may be a photoresist. In this case, first, the second surface 302 is coated with a liquid resist material to form the resist layer 37A on the second surface 302. After the coating, a step of heating the resist layer 37A may be performed. Subsequently, a photolithography process for exposing and developing the resist layer 37A is performed. As a result, the resist opening 371A can be formed in the resist layer 37A.

Although not illustrated, the resist layer 37A may be a silicon oxide film partially formed on the second surface 302. The silicon oxide film is formed, for example, by partially performing a thermal oxidation treatment or the like on the second surface 302.

Subsequently, as illustrated in Fig. 9, a screw hole forming step is performed in which the first layer 30 is etched from the second surface 302 side to form a screw hole 30H in the first layer 30. The etching in the screw hole forming step may be dry etching using an etching gas.

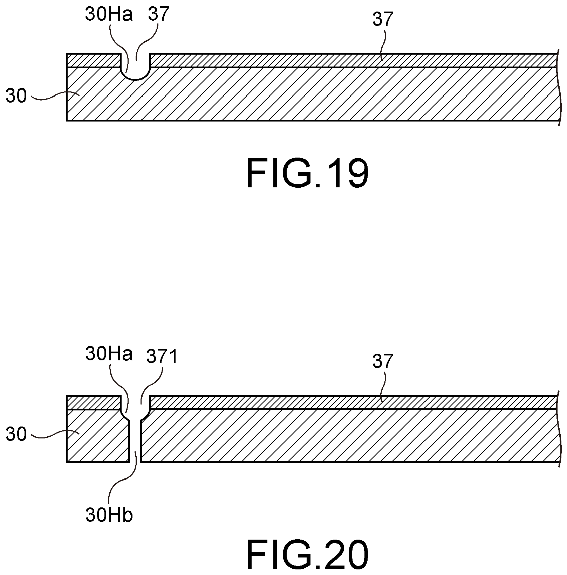

The screw hole 30H includes a first portion 30Ha that receives a head 71 of a screw 70 and a second portion 30Hb through which a shaft 72 of the screw 70 is inserted. The diameter of the second portion 30Hb is substantially uniform in the thickness direction of the first layer 30, whereas the diameter of the first portion 30Ha increases in the direction from the first surface 301 toward the second surface 302. A method of forming such a screw hole 30H is not particularly limited, but for example, the following method can be employed. First, as illustrated in Fig. 19, the first layer 30 is etched by isotropic etching. As a result, the first portion 30Ha is formed in the first layer 30. Because the first portion 30Ha is formed by isotropic etching, the diameter of the first portion 30Ha increases in the direction from the first surface 301 toward the second surface 302. Thereafter, as illustrated in Fig. 20, the bottom of the first portion 30Ha is etched by anisotropic etching to form the second portion 30Hb. Because the second portion 30Hb is formed by anisotropic etching, the diameter of the second portion 30Hb can be made substantially uniform in the thickness direction of the first layer 30. Through these steps, the screw hole 30H including the first portion 30Ha and the second portion 30Hb can be formed.

The etching step of forming the second portion 30Hb may be deep reactive ion etching. In this case, a plasma of etching gas is used. The etching gas is, for example, SF₆ gas.

After the screw hole 30H is formed in the first layer 30, the resist layer 37A is removed. For example, a resist processing liquid is supplied to the second surface 302.

When the resist layer 37A is a photoresist, the resist processing liquid contains, for example, N-methyl-2-pyrrolidone. The resist layer 37A may be removed by irradiating the resist layer 37A with oxygen plasma.

When the resist layer 37A is a silicon oxide film, the resist processing liquid contains, for example, hydrofluoric acid. Alternatively, the resist layer 37A may be removed by dry etching using CF₄ gas or the like.

Subsequently, as illustrated in Fig. 10, an intermediate layer 50 is formed on the second surface 302 of the first layer 30. The intermediate layer 50 may be formed on the entire second surface 302. The intermediate layer 50 may also be formed in the screw hole 30H. The intermediate layer 50 may be formed by, for example, a vacuum deposition method such as sputtering.

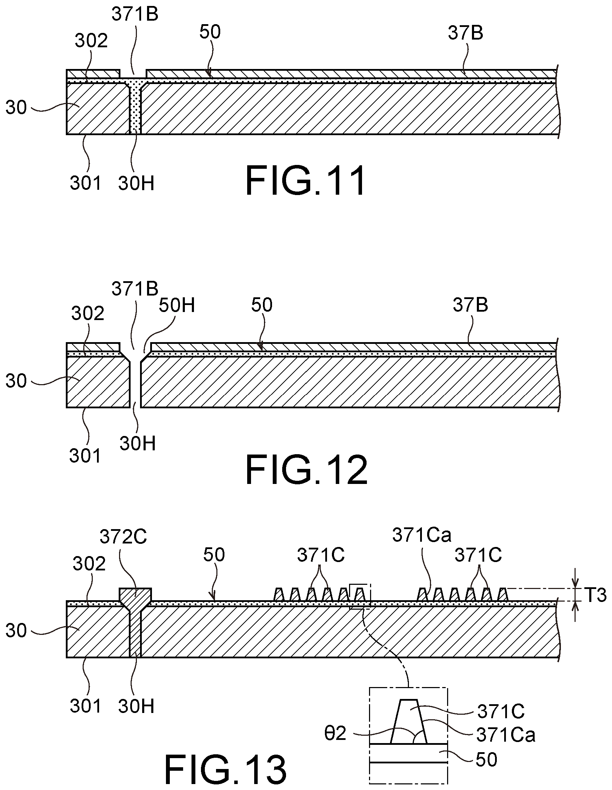

Subsequently, as illustrated in Fig. 11, a resist layer 37B is partially formed on the intermediate layer 50. A resist opening 371B is formed in the resist layer 37B. The resist opening 371B is formed so as to face the screw hole 30H.

The resist layer 37B may be a photoresist. In this case, first, the intermediate layer 50 is coated with a liquid resist material to form the resist layer 37B on the intermediate layer 50. After the coating, a step of heating the resist layer 37B may be performed. Subsequently, a photolithography process for exposing and developing the resist layer 37B is performed. As a result, the resist opening 371B can be formed in the resist layer 37B.

Subsequently, as illustrated in Fig. 12, the intermediate layer 50 is etched from the resist layer 37B side. As a result, a screw hole 50H is formed in the intermediate layer 50, and the intermediate layer 50 in the screw hole 30H is removed. The screw hole 50H is a portion of the screw hole 20H that extends within the intermediate layer 50. The etching for removing the intermediate layer 50 may be dry etching using an etching gas.

Subsequently, the resist layer 37B is removed. For example, a resist processing liquid is supplied to the intermediate layer 50.

When the resist layer 37B is a photoresist, the resist processing liquid contains, for example, N-methyl-2-pyrrolidone. The resist layer 37B may be removed by irradiating the resist layer 37B with oxygen plasma.

Subsequently, as illustrated in Fig. 13, a resist pattern forming step of forming a plurality of resist protrusions 371C and 372C on the intermediate layer 50 is performed. The resist protrusions 371C are formed in a pattern corresponding to second openings 41. The resist protrusions 371C are formed at positions overlapping the second openings 41 on the intermediate layer 50 in plan view. The resist protrusions 372C are formed at positions overlapping the screw holes 50H and 30H. The resist protrusions 372C fill the screw holes 50H and 30H and protrude from the screw holes 50H and 30H.

The resist protrusions 371C and 372C may be a photoresist. In this case, the photoresist may be a positive resist. The positive resist is, for example, iP5700, PMER-P-LA900PM, or PMER-P7100 manufactured by Tokyo Ohka Kogyo Co., Ltd., NPR9700 manufactured by Nagase ChemteX Corporation, or the like.

A height T3 of the resist protrusions 371C and 372C is defined as a distance between a top of the resist protrusions 371C and 372C and a surface of the intermediate layer 50. The height T3 is greater than the thickness of the second layer 40. The height T3 may be, for example, 2.0 µm or more, 3.0 µm or more, or 4.0 µm or more. The thickness of the second layer 40 may be, for example, 7 µm or less, 12 µm or less, or 27 µm or less.

A sidewall surface of each of the resist protrusions 371C has a tapered surface 371Ca that narrows inward as it extends away from the intermediate layer 50. Specifically, the shape of the resist protrusion 371C may be a truncated pyramid shape or a truncated cone shape as a whole. An angle θ2 between the tapered surface 371Ca and the surface of the intermediate layer 50 may be the same as the angle θ1 between the tapered surface 42a of the second opening 41 and the third surface 401.

The resist pattern forming step includes, for example, a resist layer forming step, an exposure step, and a developing step.

The resist layer forming step is a step of forming a resist layer on the intermediate layer 50. The resist layer forming step includes, for example, a step of applying a liquid resist to the intermediate layer 50. The resist layer forming step may include a step of heating the liquid resist on the intermediate layer 50. The liquid resist is dried to form a resist layer.

In the exposure step, the resist layer is irradiated with light so that, in the subsequent developing step, the resist layer remains in portions corresponding to the second openings 41 and the screw hole 20H in the resist layer, and the resist layer in the other portions on the intermediate layer 50 is removed. Specifically, since the resist layer is a positive resist, the resist layer in the other portions on the intermediate layer 50 is irradiated with light. The light is, for example, an i-line. The i-line is a spectral line of mercury having a wavelength of 365 nm.

By developing the resist layer after the exposure step, a plurality of resist protrusions 371C and 372C are obtained on the intermediate layer 50. The developer contains, for example, tetramethylammonium hydroxide (TMAH).

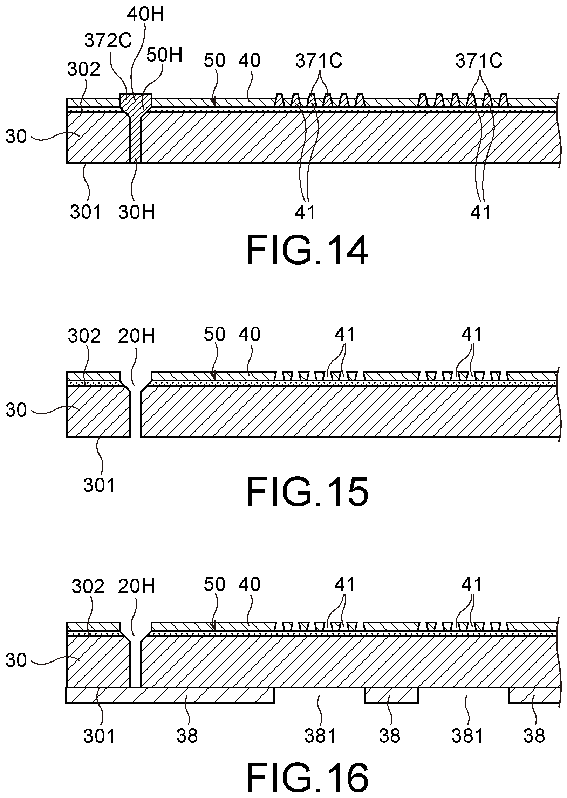

Subsequently, a second layer forming step is performed. Specifically, as illustrated in Fig. 14, a plating process is performed on the intermediate layer 50 on which the resist protrusions 371C and 372C are formed. As a result, a second layer 40 is formed. In the second layer 40, second openings 41 and a screw hole 40H are formed corresponding to the resist protrusions 371C and 372C. The screw hole 40H is a portion of the screw hole 20H that extends within the second layer 40.

The plating process may be an electrolytic plating process. Specifically, a plating power source is connected to the intermediate layer 50, and a laminate including the first layer 30, the intermediate layer 50, and the resist protrusions 371C and 372C is immersed in a plating bath containing a plating solution. As a result, metal is deposited in gaps between the plurality of resist protrusions 371C and 372C on the intermediate layer 50, and the second layer 40 is formed. Examples of the plating solution can include a mixed solution of a solution containing a nickel compound and a solution containing an iron compound. For example, a mixed solution of a solution containing nickel sulfamate or nickel bromide and a solution containing ferrous sulfamate can be used.

Subsequently, as illustrated in Fig. 15, the resist protrusions 371C and 372C are removed. At this time, not only the resist protrusions 371C in the second openings 41 and the resist protrusions 372C in the screw holes 40H but also the resist protrusions 372C in the screw holes 50H and 30H are removed. For example, the resist protrusions 371C and 372C may be removed by exposing and developing the resist protrusions 371C and 372C. The developer contains, for example, tetramethylammonium hydroxide (TMAH). Alternatively, the resist protrusions 371C and 372C may be removed by bringing a resist processing liquid into contact with the resist protrusions 371C and 372C. The resist processing liquid contains, for example, N-methyl-2-pyrrolidone.

Subsequently, as illustrated in Fig. 16, a resist layer 38 is partially formed on the first surface 301 of the first layer 30. Resist openings 381 are formed in the resist layer 38 so as to face the first openings 31.

The resist layer 38 may be a photoresist. In this case, first, the first surface 301 is coated with a liquid resist material to form the resist layer 38 on the first surface 301. After the coating, a step of heating the resist layer 38 may be performed. Subsequently, a photolithography process for exposing and developing the resist layer 38 is performed. As a result, the resist openings 381 can be formed in the resist layer 38.

Although not illustrated, the resist layer 38 may be a silicon oxide film partially formed on the first surface 301. The silicon oxide film is formed, for example, by partially performing a thermal oxidation treatment or the like on the first surface 301. The silicon oxide film may be formed on the first layer 30 before the intermediate layer 50 and the second layer 40 are stacked on the first layer 30.

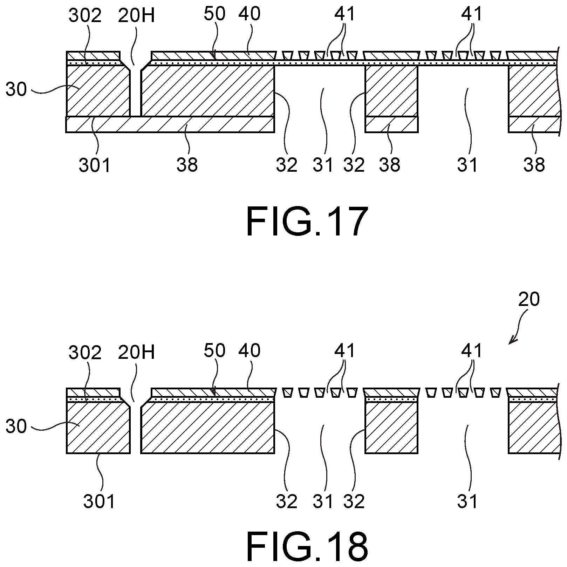

Subsequently, as illustrated in Fig. 17, a first layer processing step is performed in which the first openings 31 are formed in the first layer 30 by etching the first layer 30 from the first surface 301 side. The etching in the first layer processing step may be dry etching using an etching gas. The etching gas is an example of the etchant described above. Since the intermediate layer 50 has resistance to the etchant, as illustrated in Fig. 17, progress of the etching to the second layer 40 can be suppressed. The etching step of forming the first openings 31 may be deep reactive ion etching.

After the holes reach the intermediate layer 50, a step of removing the resist layer 38 may be performed. For example, a resist processing liquid is supplied to the first surface 301.

When the resist layer 38 is a photoresist, the resist processing liquid contains, for example, N-methyl-2-pyrrolidone. The resist layer 38 may be removed by irradiating the resist layer 38 with oxygen plasma.

When the resist layer 38 is a silicon oxide film, the resist processing liquid contains, for example, hydrofluoric acid. The resist layer 38 may be removed by dry etching using CF₄ gas or the like.

After the first layer processing step, a step of removing the intermediate layer 50 may be performed. For example, an etchant for the intermediate layer 50 is supplied to the first openings 31. As a result, as illustrated in Fig. 18, the intermediate layer 50 overlapping the first openings 31 in plan view can be removed. The etching of the intermediate layer 50 may be dry etching using a fluorine-based gas or the like, or may be wet etching using an acidic etching solution.

The order of the step of removing the resist layer 38 and the step of removing the intermediate layer 50 is not particularly limited. These steps may be performed simultaneously.

Next, a method for manufacturing a frame 60 will be described. First, a plate-like member containing the above-described glass material or metal material is prepared, and the plate-like member is cut to produce a frame 60 having a third opening 61 and screw holes 60H. As a cutting tool for cutting the plate-like member, a drill, a bite, a milling cutter, an end mill, or the like can be used.

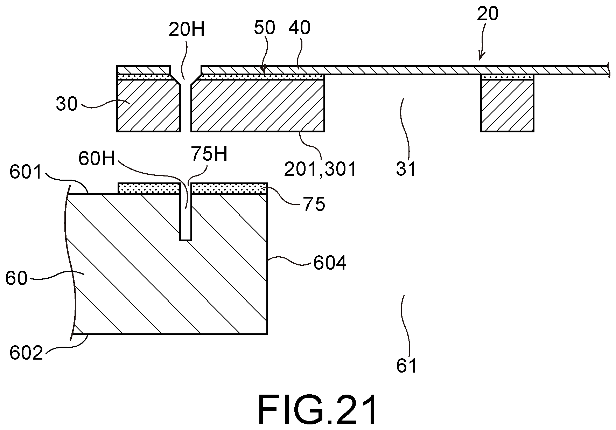

After producing the mask 20 and the frame 60, an attachment step of attaching the frame 60 to the mask 20 is performed. Specifically, as illustrated in Fig. 21, a buffer material 75 is circumferentially arranged on a fifth surface 601 of the frame 60 along an edge of the third opening 61. Through holes 75H facing the screw holes 60H are formed in the buffer material 75. Next, an entrance surface 201 of the mask 20 and the buffer material 75 are disposed to face each other, and the mask 20 is arranged on the buffer material 75. At this time, the mask 20 is positioned with respect to the frame 60 by using the screw holes 60H of the frame 60 and/or the through holes 75H of the buffer material 75 and the screw holes 20H of the mask 20. Thereafter, screws 70 are inserted into the screw holes 20H, the through holes 75H, and the screw holes 60H from the mask 20 side, and the mask 20 is fastened to the frame 60 as illustrated in Fig. 5A. Through these steps, a mask assembly 15 is manufactured.

Next, an example of a method for manufacturing an organic device 100 using such a mask assembly 15 will be described.

First, a substrate 110 on which first electrodes 120 are formed is prepared. The substrate 110 may be a silicon wafer. The first electrodes 120 may be formed by, for example, forming a conductive layer constituting the first electrodes 120 on the substrate 110 by a vacuum deposition method or the like, and then patterning the conductive layer by a photolithography method or the like. The patterning of the conductive layer may be performed using an apparatus for performing a semiconductor manufacturing process. An insulating layer 160 located between two adjacent first electrodes 120 may be formed on the substrate 110.

Subsequently, organic layers 130 including first organic layers 130A, second organic layers 130B, and the like are formed on the first electrodes 120. For example, first, a mask assembly 15 including a first mask 20 is installed in a vapor deposition apparatus 10, and the first organic layers 130A are formed by a vapor deposition method using the first mask 20. The first mask 20 includes second openings 41 corresponding to the first organic layers 130A. Subsequently, a mask assembly 15 including a second mask 20 is installed in the vapor deposition apparatus 10, and the second organic layers 130B are formed by a vapor deposition method using the second mask 20. The second mask 20 includes second openings 41 corresponding to the second organic layers 130B. Subsequently, a mask assembly 15 including a third mask 20 is installed in the vapor deposition apparatus 10, and third organic layers are formed by a vapor deposition method using the third mask 20. The third mask 20 includes second openings 41 corresponding to the third organic layers. The frame 60 is gripped when each mask assembly 15 is installed in the vapor deposition apparatus 10 and when each mask assembly 15 is taken out from the vapor deposition apparatus 10. Therefore, the possibility that the first layer 30 is damaged or the second layer 40 is deformed is suppressed. In the vapor deposition apparatus 10, the frame 60 is supported by a mask holder 9. Therefore, the possibility that the mask holder 9 interferes with a first opening 31 of the first layer 30 and/or the second openings 41 of the second layer 40 is suppressed. In other words, the possibility that deposition of a vapor deposition material on the substrate 110 is prevented by the mask holder 9 is suppressed.

Subsequently, second electrodes 140 are formed on the organic layers 130. For example, as illustrated in Fig. 1, the second electrodes 140 may be formed on the entire first surface 111 by a vacuum deposition method or the like. Alternatively, although not illustrated, the second electrodes 140 may be formed by a vapor deposition method using a mask 20 in the same manner as the organic layers 130. After that, a sealing layer (not illustrated) or the like may be formed on the second electrodes 140. In this way, the organic device 100 can be obtained.

A plurality of organic devices 100 may be formed on one substrate 110. One organic device 100 may correspond to one first opening 31 of the mask 20. In this case, a step of cutting the substrate 110 may be performed. For example, the substrate 110 is cut along a region of the substrate 110 corresponding to the inner region 36 of the mask 20. As a result, a plurality of organic devices 100 can be obtained.

Effects of the mask 20 when the organic layers 130, the second electrodes 140, and the like are formed by a vapor deposition method using a mask 20 will be described.

The mask 20 includes the first layer 30 containing silicon or a silicon compound. Therefore, when the substrate 110 contains silicon, it is possible to suppress occurrence of a difference between thermal expansion occurring in the substrate 110 and thermal expansion occurring in the mask 20. Therefore, it is possible to suppress a decrease in the accuracy of the positions, shapes, and the like of the vapor deposition layers, such as the organic layers 130 or the second electrodes 140, due to thermal expansion of the mask 20. Therefore, an organic device 100 having a high element density can be provided.

The mask 20 includes the second layer 40 including a plurality of second openings 41. By providing the second layer 40 separately from the first layer 30, the thickness of the second layer 40 can be reduced, thereby occurrence of a shadow in the vapor deposition step can be suppressed. In addition, by appropriately ensuring the spacing S6 between the first wall surface 32 and a second opening 41 in plan view, the thickness of the first layer 30 can be appropriately ensured while suppressing a shadow.

The above-described embodiment can be modified in various ways. Hereinafter, the modifications will be described with reference to the drawings as necessary. In the following description and the drawings used in the following description, parts that can be configured substantially the same as those of the above-described embodiment are denoted by the same reference signs as those used for corresponding parts in the above-described embodiment. Redundant descriptions will be omitted. In addition, in a case where it is apparent that the effects obtained in the above-described embodiment can also be obtained in the modifications, the description thereof may be omitted.

For example, the mask 20 does not necessarily include the intermediate layer 50 between the first layer 30 and the second layer 40. In this case, the second surface 302 of the first layer 30 and the third surface 401 of the second layer 40 may be directly connected to each other.

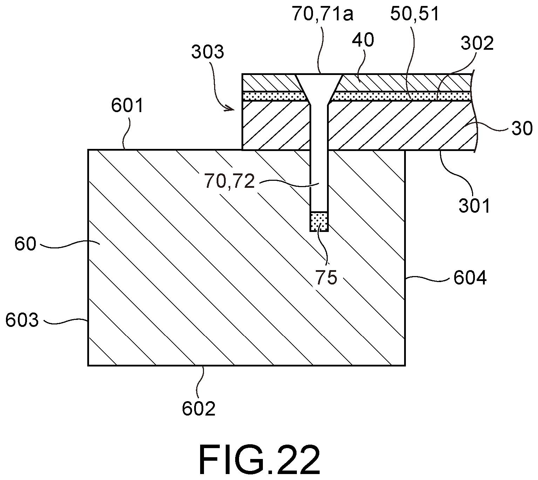

As illustrated in Fig. 22, the buffer material 75 may be disposed between a tip of the shaft 72 of the screw 70 and the frame 60. In this case, the possibility that the frame 60 is damaged by stress applied from the screw 70 to the frame 60 is suppressed.

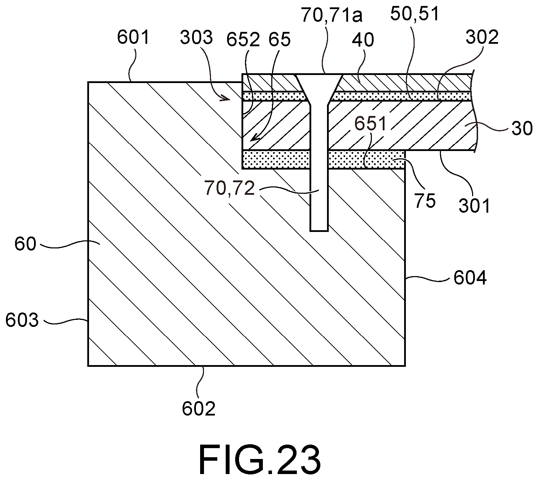

As illustrated in Fig. 23, a stepped portion 65 may be provided on an inner peripheral portion of the frame 60. The stepped portion 65 is recessed in a direction from the fifth surface 601 toward the sixth surface 602. The stepped portion 65 is formed by a surface 651 that extends from an inner edge 604 of the frame 60 toward the outer edge 603 and a surface 652 that connects the surface 651 and the fifth surface 601. The surface 651 constitutes a part of the fifth surface 601. The surface 652 connects the remaining part of the fifth surface 601 and the surface 651. The surface 652 constitutes a part of the inner surface of the frame 60. In this case, at least a part of the mask 20 may be received in the stepped portion 65, more specifically, in the space defined by the surface 651 and the surface 652. In this case, the outer edge of the mask 20 is surrounded by the frame 60. As a result, the possibility that the outer region 25 of the mask 20 (in particular, the outer region 35 of the first layer 30) is damaged is further effectively suppressed.

When at least a part of the mask 20 is received in the stepped portion 65 of the frame 60, preferably, the exit surface 202 of the mask 20 is flush with the fifth surface 601 of the frame 60 or protrudes from the fifth surface 601. In these cases, when vapor deposition layers are formed on the substrate 110 or a component on the substrate 110 through the mask 20, the exit surface 202 of the mask 20 can be brought into contact with the substrate 110 or the component on the substrate 110.

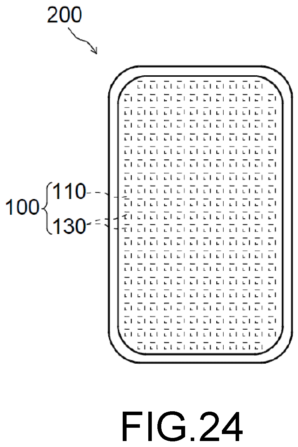

Fig. 24 is a view illustrating an example of a device 200 including the organic device 100. The device 200 includes a substrate 110 and organic layers 130. The organic layers 130 are layers formed by a vapor deposition method using the mask 20. The device 200 is, for example, a smartphone. The device 200 may be a tablet terminal, a wearable terminal, or the like. The wearable terminal is a smart glass, a head-mounted display, or the like.

The mask assembly 15 according to the embodiment described above includes a mask 20 and a frame 60 connected to the mask 20. The mask 20 includes a first layer 30 and a second layer 40. The first layer 30 includes a first surface 301, a second surface 302 located opposite to the first surface 301, at least one first opening 31 penetrating through the first layer from the first surface 301 to the second surface 302, an outer edge 303, and an outer region 35 located between the outer edge 303 and the first opening 31 in plan view. The second layer 40 includes a third surface 401 facing toward the second surface 302, a fourth surface 402 located opposite to the third surface 401, and a plurality of second openings 41 penetrating through the second layer from the third surface 401 to the fourth surface 402 and overlapping the first opening 31 in plan view. The frame 60 faces toward the first surface 301 of the outer region 35 of the first layer 30. At least a part of the frame 60 extends outward beyond the outer edge 303 of the first layer 30 in plan view. The mask 20 is fixed to the frame 60 by a screw 70. In this case, since the frame 60 can be gripped when the mask 20 is handled, the possibility of damage to the mask 20 is suppressed. As a result, handling of the mask 20 is facilitated. In addition, the mask 20 can be easily fixed to the frame 60, and the mask assembly 15 can be easily manufactured.

It is also possible to appropriately combine a plurality of components disclosed in the above embodiments and modifications as necessary. Alternatively, some components may be deleted from all the components disclosed in the above embodiments and modifications.

## Claims

1. A mask assembly comprising:
a mask; and
a frame connected to the mask,
wherein the mask includes
a first layer that includes a first surface, a second surface located opposite to the first surface, at least one first opening penetrating through the first layer from the first surface to the second surface, an outer edge, and an outer region located between the outer edge and the first opening in plan view, and
a second layer that includes a third surface facing toward the second surface, a fourth surface located opposite to the third surface, and a plurality of second openings penetrating through the second layer from the third surface to the fourth surface and overlapping the first opening in plan view,
the frame faces toward the first surface of the outer region of the first layer,
at least a part of the frame extends outward beyond the outer edge of the first layer in plan view, and
the mask is fixed to the frame by a screw.

2. The mask assembly according to claim 1, wherein the first layer contains silicon or a silicon compound, and
the frame contains glass or metal.

3. The mask assembly according to claim 1, further comprising a buffer material between the mask and the frame.

4. The mask assembly according to claim 1, wherein the mask and the frame are disposed in this order in a direction from a head toward a shaft of the screw, and
the mask assembly further comprises a buffer material between a tip of the shaft of the screw and the frame.

5. The mask assembly according to claim 1, wherein the mask and the frame are disposed in this order in a direction from a head toward a shaft of the screw, and
a top surface of the head of the screw is flush with the fourth surface of the second layer, or is located between the fourth surface and the first surface of the first layer.

6. The mask assembly according to claim 1, wherein the mask is fixed to the frame by two or more screws.

7. The mask assembly according to claim 1, wherein the mask is fixed to the frame by one or more pairs of screws, the pairs each being arranged with the plurality of second openings interposed therebetween in plan view.

8. The mask assembly according to claim 1, wherein a stepped portion that receives at least a part of the mask is formed in the frame.

9. The mask assembly according to claim 1, wherein the mask is detachably fixed to the frame.

10. The mask assembly according to claim 1, wherein the screw is made of the same material as the frame.

11. A method for manufacturing an organic device, the method comprising a step of forming organic layers on a substrate by a vapor deposition method using the mask assembly according to any one of claims 1 to 10.
